(19) Europäisches Patentamt European Patent Office Office européen des brevets

(11) **EP 2 383 897 A1**

(12) **EUROPEAN PATENT APPLICATION**

(43) Date of publication:
**02.11.2011 Bulletin 2011/44**

(51) Int Cl.:
**H04B 3/46** *(2006.01)*   **G01R 27/06** *(2006.01)*

(21) Application number: **10305447.4**

(22) Date of filing: **28.04.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA ME RS**

(71) Applicant: **Alcatel Lucent**
**75008 Paris (FR)**

(72) Inventors:
• **Guenach, Mamoun**
  **1830, Machelen (BE)**
• **Maes, Jochen**
  **2431, Veerle (BE)**

• **Boets, Patrick**
  **2801, Heffen (BE)**
• **Van Biesen, Leonard**
  **9300, Aalst (BE)**
• **Neus, Carine**
  **1020, Brussel (BE)**

(74) Representative: **ALU Antw Patent Attorneys Intellectual Property and Standards Copernicuslaan 50 2018 Antwerp (BE)**

Remarks:
Amended claims in accordance with Rule 137(2) EPC.

(54) **Binder topology identification for a telecommunication network**

(57)   A binder topology identification module and method to identify the topology of a binder of telecommunication lines (i, j) by means of Single-Ended Line Testing SELT. The module comprises first (CMi) and second (CMj) common mode module coupled a first line (i) and a second line (j) of the bundle for simultaneously applying a first (V1i, V2i) and a second (V1j, V2j) common mode signal on the two wires of the respective line. The first and the second common mode signals are applied in a differential mode to the lines with respect to a ground reference. The module further comprises a transmitter (TR) to receive an input signal (E) for controlling the first and second common mode modules, and a receiver (RC) to measure the resulting signals (SELT-PMD) on both the first and second lines for providing a received phantom mode signal (V). A processing unit adapted to analyze the phantom mode signal for deriving thereof binder topology identification completes the binder topology identification module.

Fig. 1

**Description**

The present invention relates to a method to identify the topology of a binder of telecommunication lines, said method comprising the step of performing Single-Ended Line Testing SELT on said lines of the bundle.

Binder topology identification is crucial for the management of a copper access telecommunication network, such as network diagnosis, binder optimization and prequalification of binder-sensitive technologies (e.g. vectoring). Binder topology identification allows constructing "maps" to link the DSL lines, also called pairs, to locations in the physical network.

Current methods use post-processing of multiple single line Single-Ended Line Testing SELT, i.e. testing of a subscriber loop from a single location, e.g. the Central Office CO, by means of reflectometry. This technique is quite sensitive to the quality of the SELT-PMD (Physical Medium Dependent) measurement and the processing.

Binder information, e.g. about grouping of lines that are in a same binder, is hard to obtain with this type of SELT measurement. Attempts have been made to determine whether lines reside in the same binder based on correlation of individual SELT measurements taken on each line. The correlation results generally turn out unsatisfactory due to several reasons:

- first, variations between SELT measurements of different lines in the same binder are observed due to channel imperfection and measurement accuracy limitations,
- secondly, lines not sharing the same binder, but having a similar loop make-up, e.g. a gauge change at the same distance from the access node, may show a high correlation in their respective SELT measurements, which will lead to a false positive, and
- thirdly, the reflections near cross-connects or gauge changes can be insufficiently large, leading to non-detection of lines in the same binder (false negative).

As a result, binder topology identification is made very difficult if not impossible with the current methods.

An object of the present invention is to provide a method to identify the topology of a binder of telecommunication lines that is improved with respect to the above known methods.

According to the invention, an embodiment of this object is achieved due to the fact that said method comprises the steps of

- applying a first common mode signal on the two wires of a first line of said bundle and simultaneously applying a second common mode signal on the two wires of a second line of said bundle, said first common mode signal and said second common mode signal being applied in a differential mode with respect to a ground reference,
- measuring the resulting signals on both first and second lines for providing a received phantom mode signal, and
- analyzing said phantom mode signal for deriving therefrom binder topology identification.

The basic idea of this embodiment consists of using Single-Ended Line Testing / Physical Medium Dependent SELT-PMD measurements over phantom mode. To this end, a SELT measurement is performed on the phantom mode of two lines, which are preferably Digital Subscriber Line DSL lines. Such phantom mode is the differential mode between the two lines, where each line, or twisted pair, carries a common mode signal. In this way, it can be shown that accurate binder topology identification and loop make-up can be obtained.

In a preferred characterizing embodiment of the present method, said first common mode signal and said second common mode signal are synchronous and identical, except for a sign inversion.

In this way, the complexity for deriving the binder topology identification from the phantom mode signal is reduced.

Another characterizing embodiment of the present method is that time domain reflectometry TDR is used, that said step of analyzing comprises using the difference of said measured signals for obtaining said phantom mode signal, and that binder topology identification is derived from a conversion of the time axis of the time domain representation of said phantom mode signal into a distance axis.

The time domain representation is especially intuitive when the time axis is converted to a distance axis. The amplitude or envelope of the measurement shows peaks and valleys, where peaks indicate large reflection such as those occurring near the start (near-end) or end (far-end) of the line or at intermediate discontinuities.

Also another characterizing embodiment of the present method is that frequency domain reflectometry FDR is used, that said step of analyzing consists of using the difference of said measured signals for obtaining said phantom mode signal, that said phantom mode signal is converted to time domain by means of Fourier transform, and that binder topology identification is derived from a conversion of the time axis of the time domain representation of said phantom mode signal into a distance axis.

In case frequency domain reflectometry FDR is used, a repetitive signal is preferably transmitted on the differential mode while simultaneously listening (measured signals) at the same location to detect the amplitude and phase change. A representation on a distance axis is obtained by first converting to time domain using a Fourier transform.

Another characterizing embodiment is that said conversion of said time axis into said distance axis is function of the velocity of propagation of said common mode signals.

A further object of the present invention is to provide a binder topology identification module adapted to identify the topology of a binder of telecommunication lines and which is optimized with respect to the known modules.

According to an embodiment of the present invention, this further object is achieved due to the fact that said binder topology identification module comprises

- a first common mode module coupled to a first line of said bundle and adapted to apply a first common mode signal on the two wires of said first line,
- a second common mode module coupled to a second line of said bundle and adapted to apply a second common mode signal on the two wires of said second line,
- a transmitter adapted to receive an input signal having a known spectral content and to control said first and second common mode modules,
- a receiver adapted to measure the resulting signals on both said first and second lines to provide a received phantom mode signal, and
- a processing unit adapted to analyze said phantom mode signal for deriving therefrom binder topology identification.

This embodiment is adapted to identify the topology of a binder of telecommunication lines in an optimal way.

Another characterizing embodiment of the present invention is that said first common mode module and said second common mode module are adapted to simultaneously apply identical first and second common mode signals on the two wires of their associated line respectively, and to apply said first common mode signal and said second common mode signal in a differential mode with respect to a ground reference.

The creation of a device that can perform phantom mode measurements is technically quite complex, since for the purpose of binder identification it is desired that such phantom mode measurements be performed on any two lines in the network, leading to a complexity that scales with the square of the targeted number of lines. The complexity is here reduced by stating that the same goal is achieved by simultaneously applying a first common mode signal on one line and by simultaneously applying a second common mode signal on a second port. This results in a differential signal between the two lines or twisted pairs. The complexity of this method scales linearly with the targeted number of lines.

Again another characterizing embodiment of the present invention is that said receiver is adapted to use the difference of said measured common mode signals for obtaining said phantom mode signal.

By transmitting the first and the second common mode signals synchronously and by ensuring that both signals are exactly the same (except for a sign inversion), the subtraction of the so-obtained simultaneous measurements results in the desired phantom mode signal that can be used as relevant input for binder identification.

Another characterizing embodiment of the present invention is that said binder topology identification module comprises a phantom mode system including said first common mode module, said second common mode module, said transmitter and said receiver, and that said phantom mode system is located in a telecommunication DSL modem or in a telecommunication access node.

Although the phantom mode system may be realized as a separate measuring device, it can also advantageously be located in a DSL modem or in an access node.

Another characterizing embodiment of the present invention is that said processing unit is a dedicated measuring device, is located in said telecommunication access node or is located in a central telecommunication management entity, such as for instance a Network Analyzer.

The present invention further relates to a phantom mode system adapted to transceive phantom mode signals on a binder of telecommunication lines.

A characterizing embodiment of this phantom mode system comprises

- a plurality of common mode module each common mode module being coupled to a distinct line and being adapted to apply a first common mode signal on the two wires of said line,
- a transmitter adapted to receive an input signal having a known spectral content and to control said plurality of common mode modules, and
- a receiver adapted to measure the resulting signals on said lines to provide a received phantom mode signal.

In this way, the phantom mode system is used to create a communication channel with a far end transceiver over the phantom mode.

Further characterizing embodiments of the present method and binder topology identification module are mentioned in the appended claims.

It is to be noticed that the term "comprising", used in the claims, should not be interpreted as being restricted to the means listed thereafter. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. Thus, the scope of the expression "a device A coupled to a device B" should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:

Fig. 1 represents a phantom mode system PMS forming part of a binder topology identification module according to the invention. The PMS is adapted to transceive phantom mode signals. It is further adapted to identify the topology of a binder of telecommunication lines;
Fig. 2 shows characteristic impedances between two lines;
Figs. 3 to 5 show various characteristic impedances in the time domain of lines in same and different binders.

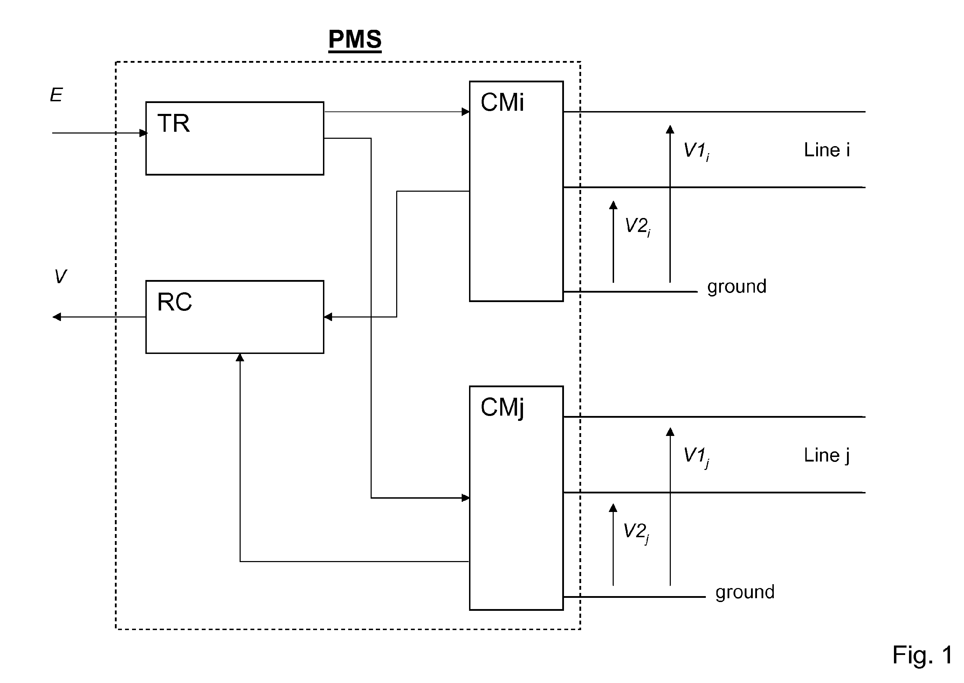

The phantom mode system PMS shown at Fig. 1 forms part of a binder topology identification module able to identify the topology of a binder of telecommunication pairs or lines i and j. Such binder information relates for instance the distance along which lines are grouped in a same binder.

To this end, the phantom mode system PMS measures phantom mode signals on the pair formed by the lines i and j. The phantom mode system PMS comprises building blocks for generating and receiving common mode voltages on the two lines i and j that form a single phantom mode pair.

The building blocks of the phantom mode system PMS are:

- a first common mode module CMi coupled to the first line i of the bundle and able to apply a first common mode signal V1i V2i given by (V1i + V2i) / 2 on the two wires of the line i,
- a second common mode module CMj coupled to the second line j of the bundle and able to apply a second common mode signal V1j, V2j given by (V1j + V2j) / 2 on the two wires of the line j,
- a transmitter TR able to receive an input signal E having a known spectral content and to control the first CMi and second CMj common mode modules, and
- a receiver or SELT measurement circuit RC able to measure the resulting Single-Ended Line Testing - Physical Medium Dependent signals (SELT-PMD) on both the first and second lines, i and j respectively, and to provide a phantom mode signal or echo signal V.

In more detail, to apply the common mode signal on the line i, the common mode module CMi uses the input signal E to generate the voltages V1i and V2i on the two wires of the line i. The same module CMi also measures the common mode echo signals on the same line i.

The second common mode module CMj has a similar behavior.

The receiver RC of the phantom mode system PMS will use both measured common mode signals on the lines i and j to provide the received phantom mode signal V by subtracting the measured signals.

In general, the phantom mode signal V is a linear combination of the wire voltages V1i, V2i, V1j and V2j, such as:

$$V = a*V1i + b*V2i + c*V1j + d*V2j$$

wherein V1i represents the voltage between a single wire of line i and the ground reference and V2i represents the voltage between the other wire of line i and the ground reference. Similarly, V1j represents the voltage between a single wire of line j and the ground reference and V2j represents the voltage between the other wire of line j and the ground reference.

The symbols a, b, c and d represent frequency dependent constants which are determined by the actual electronic and digital circuits to obtain the phantom mode voltage V.

The frequency dependent phantom mode echo response (ER) of line i and j provided by SELT is given by:

$$ERpm,ij = V/E$$

wherein the input signal E has a known spectral content and the phantom mode signal V describes the behavior of the measured phantom mode echo signals.

There exists a special case where it is possible to maximize the received phantom mode signal V and to avoid leakage into the differential line voltages. This occurs if:

$$V1i = V2i = -V1j = -V2j$$

and by using a gain factor k in the receiver RC which leads to:

$$a = b = c = d = k$$

The differential line voltages are given by V1i-V2i on line i and by V1J-V2J on line j.

The phantom mode system PMS will operate close to the design requirements of this special case in order to maximize the signal-to-noise ratio of the measurement and to minimize the differential leakage, although this leakage could even be created by design to measure simultaneously the SELT phantom mode ERpm,ij and the differential mode SELT echo responses ERdm,i and ERdm,j . Considering:

$$ERdm,i = e*(V1i-V2i)/E$$

and

$$ERdm,j = f*(V1j-V2j)/E$$

with e and f being frequency dependent constants depending on the electronic and digital circuits.

The phantom mode system PMS of the binder topology identification module is preferably located in a telecommunication DSL chip or modem or in a telecommunication access node so that a SELT measurement can easily be performed from there on the differential mode of a DSL line. For instance, each DSL modem in the access node will be able to individually sent signals on the common mode of the pair connected to the DSL modem.

The phantom mode system PMS may be included in the access node as a separate component, having access to the common mode of each attached line. In this case, only two common mode transmitter blocks need to be provisioned per unit (e.g. line termination card).

The phantom mode system PMS may also be realized as a separate measuring device, free-standing with respect to the access node. The latter is motivated by the static nature of the loop topology. This allows acquiring topology information only once (or sporadically) for each access node. Having connection possibilities similar to those available on the access node greatly facilitates the data acquisition since it merely requires the unplugging of the connectors on the access node and plugging into the measurement device.

The binder topology identification module is completed with a processing unit (not shown) coupled to an output of the receiver or SELT measurement circuit RC and able to analyze the phantom mode signal V in order to gain knowledge on the loop make-up or binder topology identification.

The SELT measurement is often referred to as SELT-PMD (Physical Medium Dependent) and is based on time domain reflectometry (TDR) or frequency domain reflectometry (FDR).

The SELT-PMD measurement is analyzed by the processing unit that may be a dedicated measuring device, residing in the telecommunication access node with the phantom mode system PMS, or residing in a central telecommunication management entity, such as a Network Analyzer.

In case of frequency domain reflectometry FDR, a repetitive signal is transmitted, e.g. from the access node, on the differential mode while simultaneously listening (receiving signal) at the same location to detect the amplitude and phase change.

In case of FDR, this processing may optionally include a step in which the measurement, i.e. the phantom mode signal V, is converted to time domain using a Fourier transform.

When represented in the time domain, the amplitude or envelope of the measurement shows peaks and valleys as a function of time, where peaks indicate large reflection such as those occurring near the start (near-end) or end (far-end) of the line or at intermediate discontinuities. Intermediate discontinuities can be caused by a gauge change or cross connection.

The time domain representation is especially intuitive when the time axis is converted to a distance axis by employing a velocity of propagation.

The distance on the x-axis then represents the distance between the point of reflection and the access node. The output of such processing of a SELT-PMD measurement results in a set of information called SELT-P (Processing) and may include knowledge on the loop make-up such as loop length, the presence of bridged taps and prequalification information such as attainable bit rate.

Summarizing, binder topology identification is obtained by using the principle of performing a SELT measurement on the phantom mode of two DSL lines i and j. Such phantom mode is the differential mode between the two lines, where each line or pair of wires carries a common mode signal. By transmitting the first (V1i + V2i) / 2 and the second (V1j + V2j) / 2 common mode signals synchronously and by ensuring that both signals are exactly the same, except for a sign inversion, the difference of the so-obtained simultaneous measurements results in the desired phantom mode signal V that can be used as relevant input for binder identification.

The way in which binder information is preferentially obtained from such phantom mode data is to revert the data to the time domain, e.g. after pre-processing in the frequency domain, and to detect the end-of-line reflection in the data. The end-of-line reflection of the phantom mode "line" corresponds to the location where the two pairs or lines on which the common mode measurement was performed split off into different direction or where one of the two pairs is for instance ended by a Customer Premises Equipment (CPE).

Binder identification is obtained by analyzing the characteristic impedance of the phantom mode. Examples of binder identification obtained by analysis of the phantom mode SELT measurement in the time domain are given below.

By representing the measurement in the time domain, a clear distinction can be made between various scenarios.

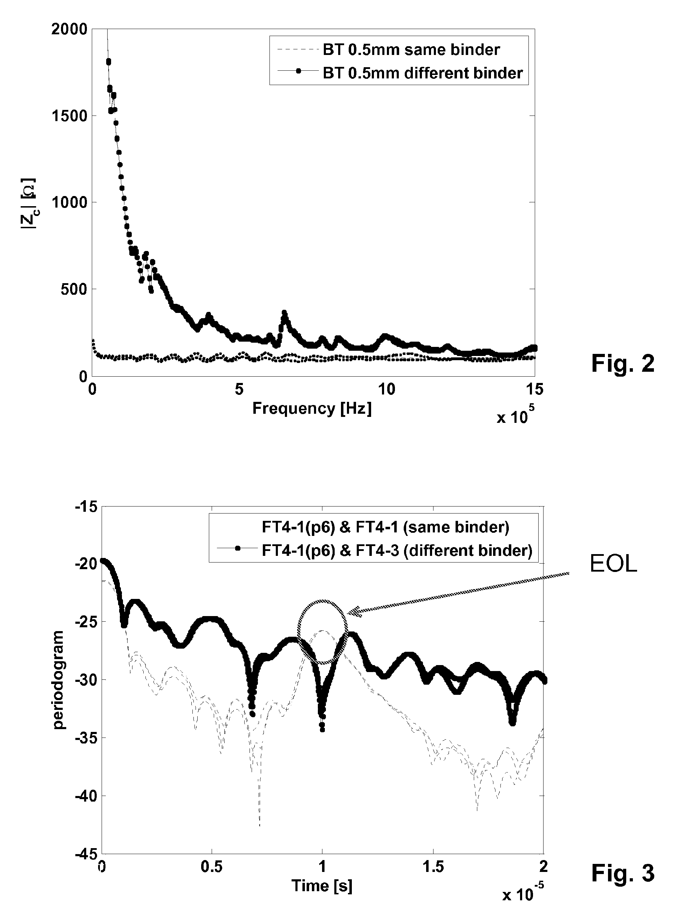

Fig. 2 shows a first scenario wherein both lines or pairs are not located in the same binder. The phantom mode channel will then look like an open network with high characteristic impedance. As a result, most energy transmitted into the line will immediately be reflected (at the beginning of the horizontal frequency-axis), leading to a strong near end reflection and a further weak reflection which carries useful binder information but is hard to distinguish amongst other reflections due to local cable non-homogeneities.

In other words, when two lines do not share the same binder at all, no end-of-line reflection will be observed. The reason for this is that the characteristic impedance of the phantom mode is then highly dependent on the distance between the two pairs that constitute the phantom mode. As such, the characteristic impedance of the phantom mode of two neighboring pairs is low, while the characteristic impedance of non-neighboring pairs is high.

Fig. 3 shows a second scenario wherein two pairs are in each others vicinity in a same binder for a certain length, and after that split off in different directions. The reflectogram of the characteristic impedance of the phantom mode suddenly increases drastically and shows an "end-of-line" EOL peak at the location of the split-off point. If the lines do not share the same binder such peak is not observed.

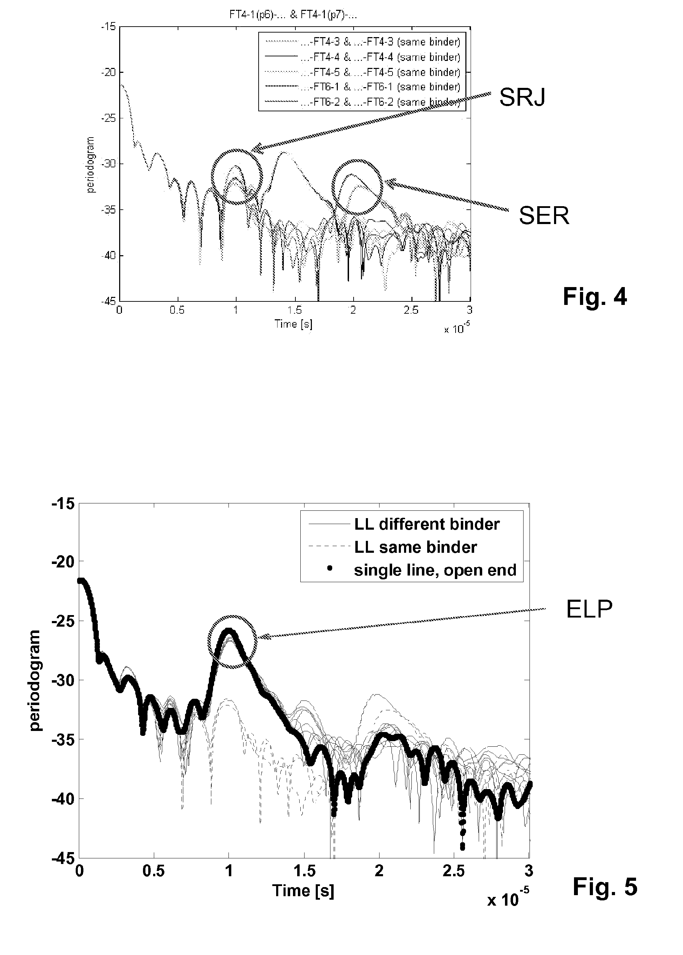

Fig. 4 shows a third scenario wherein both pairs are located in the same binder for most of their entire length. In this case, the characteristic impedance of the phantom mode will be low and a strong "end-of-line" reflection SER will be seen near the end of both pairs (note that time-axis can easily be converted to distance by exploiting the velocity of propagation).

Moreover, any possible junction between different cables that are joint together will not show up as strong reflections as long as both pairs do not split off into different directions. Such a small reflection at a junction point is indicated by SRJ at Fig. 4.

Fig. 5 shows a fourth scenario wherein the pairs share the same binder for some distance, but then either one pair is terminated at that location or that pair continues in another separate binder. In this case, the time-domain representation will show a strong reflection or end-of-line peak ELP at the location where the two pairs split off into different direction. This is due to the fact that the characteristic impedance will be low for as long as the pairs are in fairly near proximity, while the characteristic impedance will significantly increase when the pairs go off into different directions.

The phantom mode system PMS can be used to create a communication channel with a far end transceiver over the phantom mode. In this case, the phantom mode system will control the common mode modules to transmit a bit stream to a far end transceiver, e.g. downstream data to a customer premises DSL modem. Likewise, the phantom mode system will control the common mode modules to receive a bit stream from a far end transceiver, e.g. upstream data from a customer premises DSL modem. Additionally, the phantom mode system PMS may control more than two common mode modules CMi, CMj. Typically, it controls one common mode modules for each wire pair attached to a digital subscriber line access multiplexer (DSLAM) or of a line termination card within a DSLAM. In this way, the phantom mode system has the ability to maintain phantom communication over any desirable phantom mode channel, including higher-order phantom modes in which the phantom mode channel comprises more than two wire pairs. This flexibility to select the desired phantom mode channels from all possible phantom mode channels within the bundle is achieved with a complexity that scales only linearly with the amount of common mode modules, i.e. the amount of wire pairs attached to the phantom mode system.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A method to identify the topology of a binder of telecommunication lines (i, j), said method comprising the step of performing Single-Ended Line Testing SELT on said lines of the bundle,
   **characterized in that** said method comprises the steps of

   - applying a first common mode signal (V1i V2i) on the two wires of a first line (i) of said bundle and simultaneously applying a second common mode signal (V1j, V2j) on the two wires of a second line (j) of said bundle, said first common mode signal and said second common mode signal being applied in a differential mode with respect to a ground reference,
   - measuring (RC) the resulting signals (SELT-PMD) on both first (i) and second (j) lines for providing a received phantom mode signal (V), and
   - analyzing said phantom mode signal for deriving therefrom binder topology identification.

2. The method according to claim 1, **characterized in that** said first common mode signal (V1i, V2i) and said second common mode signal (V1j, V2j) are synchronous and identical, except for a sign inversion.

3. The method according to claim 1,
   **characterized in that** time domain reflectometry TDR is used,
   **in that** said step of analyzing comprises using the difference of said measured signals for obtaining said phantom mode signal (V),
   and **in that** binder topology identification is derived from a conversion of the time axis of the time domain representation of said phantom mode signal into a distance axis.

4. The method according to claim 1,
   **characterized in that** frequency domain reflectometry FDR is used,
   **in that** said step of analyzing consists of using the difference of said measured signals for obtaining said phantom mode signal (V),
   **in that** said phantom mode signal is converted to time domain by means of Fourier transform,
   and **in that** binder topology identification is derived from a conversion of the time axis of the time domain representation of said phantom mode signal into a distance axis.

5. The method according to any of the claims 3 or 4, **characterized in that** said conversion of said time axis into said distance axis is function of the velocity of propagation of said common mode signals (V1i, V2i; V1j, V2j).

6. The method according to claim 1, **characterized in that** said telecommunication lines (i, j) are DSL lines.

7. A binder topology identification module adapted to identify the topology of a binder of telecommunication lines (i, j),
   **characterized in that** said binder topology identification module comprises

   - a first common mode module (CMi) coupled to a first line (i) of said bundle and adapted to apply a first common mode signal (V1i V2i) on the two wires of said first line (i),

- a second common mode module (CMj) coupled to a second line (j) of said bundle and adapted to apply a second common mode signal (V1j, V2j) on the two wires of said second line (j),
- a transmitter (TR) adapted to receive an input signal (E) having a known spectral content and to control said first and second common mode modules,
- a receiver (RC) adapted to measure the resulting signals (SELT-PMD) on both said first and second lines to provide a received phantom mode signal (V), and
- a processing unit adapted to analyze said phantom mode signal for deriving therefrom binder topology identification.

8. The binder topology identification module according to claim 7, **characterized in that** said first common mode module (CMi) and said second common mode module (CMj) are adapted to simultaneously apply identical first (V1i V2i) and second (V1j, V2j) common mode signals on the two wires of their associated line (i, j) respectively, and to apply said first common mode signal and said second common mode signal in a differential mode with respect to a ground reference.

9. The binder topology identification module according to claim 7, **characterized in that** said receiver (RC) is adapted to use the difference of said measured common mode signals (SELT-PMD) for obtaining said phantom mode signal (V).

10. The binder topology identification module according to claim 7, **characterized in that** said binder topology identification module comprises a phantom mode system (PMS) including said first common mode module (CMi), said second common mode module (CMj), said transmitter (TR) and said receiver (RC), and **in that** said phantom mode system is located in a telecommunication DSL modem.

11. The binder topology identification module according to claim 7, **characterized in that** said binder topology identification module comprises a phantom mode system (PMS) including said first common mode module (CMi), said second common mode module (CMj), said transmitter (TR) and said receiver (RC), and **in that** said phantom mode system is located in a telecommunication access node.

12. The binder topology identification module according to any of the claims 10 or 11, **characterized in that** said processing unit is a dedicated measuring device.

13. The binder topology identification module according to claim 11, **characterized in that** said processing unit is also located in said telecommunication access node.

14. The binder topology identification module according to any of the claims 10 or 11, **characterized in that** said processing unit is located in a central telecommunication management entity.

15. A phantom mode system (PMS) adapted to transceive phantom mode signals on a binder of telecommunication lines (i, j),
**characterized in that** said phantom mode system (PMS) comprises

- a plurality of common mode module (CMi, CMj) each common mode module being coupled to a distinct line (i, j) and being adapted to apply a first common mode signal (V1i, V2i) on the two wires of said line (i, j),
- a transmitter (TR) adapted to receive an input signal (E) having a known spectral content and to control said plurality of common mode modules, and
- a receiver (RC) adapted to measure the resulting signals on said lines to provide a received phantom mode signal (V).


**Amended claims in accordance with Rule 137(2) EPC.**

1. A method to identify binder topology on any two lines (i, j) of a bundle of telecommunication lines, said bundle comprising at least a first communication line (i) and a second communication line (j), and said method comprising the step of performing Single-Ended Line Testing SELT on said first and said second lines of the bundle, **characterized in that** said method comprises the steps of

- applying a first common mode signal (V1i, V2i) on the two wires of said first line (i) of said bundle and simultaneously applying a second common mode signal (V1j, V2j) on the two wires of said second line (j) of said bundle, said first common mode signal and said second common mode signal being applied in a differential mode with respect to a ground reference,
- measuring (RC) the resulting signals (SELT-PMD) on both said first (i) and said second (j) lines for providing a received phantom mode signal (V) obtained by using the difference of the measured signals, and
- analyzing said phantom mode signal for deriving therefrom binder topology identification.

2. The method according to claim **1,** ***characterized in that*** said first common mode signal (V1i, V2i) and said second common mode signal (V1j, V2j) are synchronous and identical, except for a sign inversion.

3. The method according to claim **1,**
***characterized in that*** time domain reflectometry TDR is used,
***and in that*** binder topology identification is derived from a conversion of the time axis of the time domain representation of said phantom mode signal into a distance axis.

4. The method according to claim **1,**
***characterized in that*** frequency domain reflectometry FDR is used,
***in that*** said phantom mode signal is converted to time domain by means of Fourier transform,
***and in that*** binder topology identification is derived from a conversion of the time axis of the time domain representation of said phantom mode signal into a distance axis.

5. The method according to any of the claims **3** or **4,** ***characterized in that*** said conversion of said time axis into said distance axis is function of the velocity of propagation of said common mode signals (V1i, V2i; V1j, V2j).

6. The method according to claim 1, ***characterized in that*** said telecommunication lines (i, j) are DSL lines.

7. A binder topology identification module adapted to identify the topology of any two lines (i, j) of a bundle of telecommunication lines,
***characterized in that*** said binder topology identification module comprises

- a first common mode module (CMi) coupled to a first line (i) of said bundle and adapted to apply a first common mode signal (V1i, V2i) on the two wires of said first line (i),
- a second common mode module (CMj) coupled to a second line (j) of said bundle and adapted to apply a second common mode signal (V1j, V2j) on the two wires of said second line (j),
- a transmitter (TR) adapted to receive an input signal (E) having a known spectral content and to control said first and second common mode modules,
- a receiver (RC) adapted to measure the resulting signals (SELT-PMD) on both said first and second lines and to use the difference of the measured common mode signals for providing a received phantom mode signal (V), and
- a processing unit adapted to analyze said phantom mode signal for deriving therefrom binder topology identification.

8. The binder topology identification module according to claim **7,** ***characterized in that*** said first common mode module (CMi) and said second common mode module (CMj) are adapted to simultaneously apply identical first (V1i, V2i) and second (V1j, V2j) common mode signals on the two wires of their associated line (i, j) respectively, and to apply said first common mode signal and said second common mode signal in a differential mode with respect to a ground reference.

9. The binder topology identification module according to claim **7,**
***characterized in that*** said binder topology identification module comprises a phantom mode system (PMS) including said first common mode module (CMi), said second common mode module (CMj), said transmitter (TR) and said receiver (RC),
***and in that*** said phantom mode system is located in a telecommunication DSL modem.

10. The binder topology identification module according to claim **7,**
***characterized in that*** said binder topology identification module comprises a phantom mode system (PMS) including said first common mode module (CMi), said second common mode module (CMj), said transmitter (TR) and said receiver (RC),
***and in that*** said phantom mode system is located in a telecommunication access node.

**11.** The binder topology identification module according to any of the claims **9** or **10,** ***characterized in that*** said processing unit is a dedicated measuring device.

**12.** The binder topology identification module according to claim *10,* ***characterized in that*** said processing unit is also located in said telecommunication access node.

**13.** The binder topology identification module according to any of the claims **9** or **10,** ***characterized in that*** said processing unit is located in a central telecommunication management entity.

**14.** A phantom mode system (PMS) adapted to transceive phantom mode signals on any two lines (i, j) of a bundle of telecommunication lines, said bundle comprising at least a first communication line (i) and a second communication line (j),
***characterized in that*** said phantom mode system (PMS) comprises

- a first common mode module (CMi) coupled to said first communication line (i) and being adapted to apply a common mode signal (V1i, V2i) on the two wires of said first line (i),
- a second common mode module (CMj) coupled to said second communication line (j) and being adapted to apply said common mode signal (V1i, V2i) on the two wires of said second line (j),
- a transmitter (TR) adapted to receive an input signal (E) having a known spectral content and to control said first and said second common mode modules, and
- a receiver (RC) adapted to measure the resulting signals on said first and second communication lines to provide a received phantom mode signal (V).

Fig. 1

Fig. 2

Fig. 3

Fig. 4

Fig. 5

**Europäisches Patentamt**
**European Patent Office**
**Office européen des brevets**

# EUROPEAN SEARCH REPORT

Application Number

EP 10 30 5447

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FOUBERT W ET AL: "Modeling and validation of the parameters of a quad cable for common mode DSL applications" SIGNAL PROCESSING AND COMMUNICATION SYSTEMS, 2008. ICSPCS 2008. 2ND INTERNATIONAL CONFERENCE ON, IEEE, PISCATAWAY, NJ, USA, 15 December 2008 (2008-12-15), pages 1-6, XP031448731 ISBN: 978-1-4244-4243-0 | 15 | INV. H04B3/46 G01R27/06 |
| Y | * page 3, right-hand column - page 4, right-hand column; figures 1, 5 * ----- | 1-14 | |
| Y | NEUS C ET AL: "Transfer Function Estimation of Digital Subscriber Lines with Single Ended Line Testing" INSTRUMENTATION AND MEASUREMENT TECHNOLOGY CONFERENCE PROCEEDINGS, 2007 IEEE, IEEE, PI LNKD- DOI:10.1109/IMTC.2007.378980, 1 May 2007 (2007-05-01), pages 1-5, XP031182383 ISBN: 978-1-4244-0588-6 * page 1, right-hand column, line 1 - line 33 * ----- -/-- | 1-14 | TECHNICAL FIELDS SEARCHED (IPC) H04B G01R |

The present search report has been drawn up for all claims

| Place of search | Date of completion of the search | Examiner |
|---|---|---|
| Munich | 14 October 2010 | Giglietto, Massimo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 10 30 5447

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | BOETS P ET AL: "Preprocessing of signals for single-ended subscriber line testing" IEEE TRANSACTIONS ON INSTRUMENTATION AND MEASUREMENT IEEE USA, [Online] vol. 55, no. 5, - October 2006 (2006-10) pages 1509-1518, XP002605057 ISSN: 0018-9456 DOI: DOI:10.1109/TIM.2006.880290 Retrieved from the Internet: URL:http://ieeexplore.ieee.org/stamp/stamp.jsp?tp=&arnumber=1703893> [retrieved on 2010-10-14] * page 1509 - page 1510, left-hand column * * page 1515, right-hand column, line 1 - line 5 * | 1-14 | |

-----

TECHNICAL FIELDS
SEARCHED    (IPC)

The present search report has been drawn up for all claims

| Place of search | Date of completion of the search | Examiner |
|---|---|---|
| Munich | 14 October 2010 | Giglietto, Massimo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                                              
& : member of the same patent family, corresponding
    document

EPO FORM 1503 03.82 (P04C01)